# EUROPEAN PATENT APPLICATION

(11) **EP 1 808 703 A1**
(43) Date of publication of application: **18.07.2007**
(21) Application number: 05795867.0
(22) Date of filing: 20.10.2005
(51) Int. Cl.: G01R 31/00, G01R 29/10, H05K 9/00

(54) **ELECTRONIC DEVICE TEST BOX**

(30) Priority: 05.11.2004 JP 2004321967; 23.05.2005 JP 2005148890
(71) Applicant: Nippon Light Metal, Co., Ltd., Shinagawa-ku, Tokyo 140-8628 (JP)
(72) Inventor: SASADA, Masaaki c/o E. M. Techno Co., Ltd., Toyonaka-shi, Osaka 5610827 (JP); NAGASHIMA, Michio NIKKEI RESEARCH & DEVELOPM. CNTR, Kambara-cho, Ihara-guN, Shizuoka 4213291 (JP); UCHIDA, Katsuya Nikkeikin Aluminium Core Techn., Shinagawa-ku, Tokyo 1408628 (JP); YAMAMOTO, Katsushi c/o NTC Co., Ltd., Kaizuka-shi, Osaka 5970092 (JP); SHINDO, Masayoshi c/o Toyo Service Co., Ltd., Nagoya-shi, Aichi 4510055 (JP)
(74) Representative: Thun, Clemens
(86) International application number: PCT/JP2005/019322
(87) International publication number: WO 2006/049017

(57) **Abstract**

An electronic device test box is provided, in which a precise test of an electronic device can be performed, while maintaining radio wave shielding and absorbing capabilities of the electronic device test box, even if the electronic device test box has an opening for manipulating the electronic device or a passage for ventilation. The electronic device test box (B1) can accommodate a mobile phone (P), and is provided for testing operations of the mobile phone (P). The electronic device test box (B1) includes: a test box body (10) having a radio wave shielding capability, and a radio wave absorbing capability for absorbing a radio wave radiated by the mobile phone (P) ; a pair of hand insertion waveguides (50, 50) ; and an exhaust waveguide (60). The hand insertion waveguides (50,50) and the exhaust waveguide (60) are provided on the test box body (10) for communicating between an inside and outside of the test box body (10), and do not transmit a radio wave at a wavelength longer than a predetermined wavelength therethrough.

## Description

### FIELD OF THE INVENTION

The present invention relates to an electronic device test box for testing operations of an electronic device such as a mobile phone.

### BACKGROUND ART

It is necessary in general to perform a radio connection test or the like of an electronic device such as a mobile phone, using an actual radio wave, for confirming whether or not the electronic device operates and functions normally.

When such a radio connection test is performed, a large-sized special chamber called a radio anechoic chamber (a radio wave darkroom) or a box called a shield box (a radio wave shielding box) has been used so far (see, for example, Japanese Patent Publication No. 3097524, paragraph 0003, FIG. 5).

The conventional radio anechoic chamber is, however, inevitably a large-sized installation, because the radio anechoic chamber has to accommodate test equipment, a tester (s) and an electronic device (s) to be tested. Further, access to the conventional radio anechoic chamber is not easy during performing a test, which may result in less efficiency (productivity) of the test and/or less safety of the tester. The conventional radio anechoic chamber is also highly priced and is difficult to install, because it is generally large-sized and is for a particular use. It is therefore difficult, for example, to conveniently perform a radio connection test for confirming operations of a mobile phone in the course of designing the mobile phone, and/or after manufacturing or fixing the same.

When the radio connection test is performed in a conventional shield box, a cover of the shield box must be closed. It is not possible for a tester to perform the test, while manipulating an electronic device to be tested such as a mobile phone, with his/her hands put in the shield box.

To solve the above-mentioned problems, a radio wave shielding box for a radio connection test has been proposed. Such a radio wave shielding box includes an antenna and a unit for supplying power to the antenna. The radio wave shielding box accommodates a mobile phone so that it can be freely put in and taken out. The radio wave shielding box is covered with an electromagnetic wave shielding material having visibility and flexibility, which entirely covers an outer circumference of the radio wave shielding box, including the antenna and the mobile phone (sec, for example, Japanese Patent Publication No. 3097524, paragraphs 0008-0010, FIG. 1).

### DISCLOSURE OF THE INVENTION

In the radio shielding box disclosed in the patent document described above, however, a radio wave at a certain frequency radiated by the electronic device may reflect inside the box and resonate therein. As a result, a radio wave shielding capability of the box at a certain frequency may deteriorate, and it is not possible to perform a precise test of the electronic device.

To solve the aforementioned problem, an object of the present invention is to provide an electronic device test box, in which a precise test of an electronic device can be performed, while the electronic device test box maintains its radio wave shielding capability and radio wave absorbing capability, even if the electronic device test box has an opening for manipulating the electronic device and/or a passage for ventilation.

To achieve the aforementioned object, the present invention provides an electronic device test box which accommodates an electronic device inside thereof for testing operations of the electronic device. The electronic device test box is characterized to include a test box body having a radio wave shielding capability, and a radio wave absorbing capability of absorbing a radio wave radiated by the electronic device; and a radio wave shielding unit for shielding a radio wave, while securing circulation of air between an inside and outside of the test box body.

In the electronic device test box, the radio wave shielding unit secures circulation of air between the inside and outside of the test box body, that is, air can be taken in and out via the radio wave shielding unit. The radio wave shielding unit also secures a radio wave shielding between the inside and outside of the test box body. Therefore, a precise test of the electronic device can be performed in the test box body.

Because the test box body has the radio wave shielding capability, a radio wave, for example, from the outside will not reach inside the test box body. Further, because the test box body also has the radio wave absorbing capability of absorbing a radio wave radiated by an electronic device provided therein, the radiated radio wave is absorbed inside the test box body. This prevents the radiated radio wave from reflecting therein to cause resonance.
Hence, in the electronic device test box described above, various tests such as a radio connection test of an electronic device placed therein can be precisely performed.

In the electronic device test box according to the present invention, the radio wave shielding unit is characterized to include a metal filter for shielding a radio wave by diffraction loss.

In the electronic device test box described above, the metal filter can shield a radio wave by diffraction loss. For example, such a metal filter is constituted by assembling metal fragments together, has a space for circulating air therein, and shields a radio wave by diffraction loss.

In the electronic device test box according to the present invention, the radio wave shielding unit is characterized to include a waveguide, which is provided on the test box body for communicating between the inside and outside of the test box body, and which does not transmit a radio wave at a wavelength longer than a predetermined wavelength.

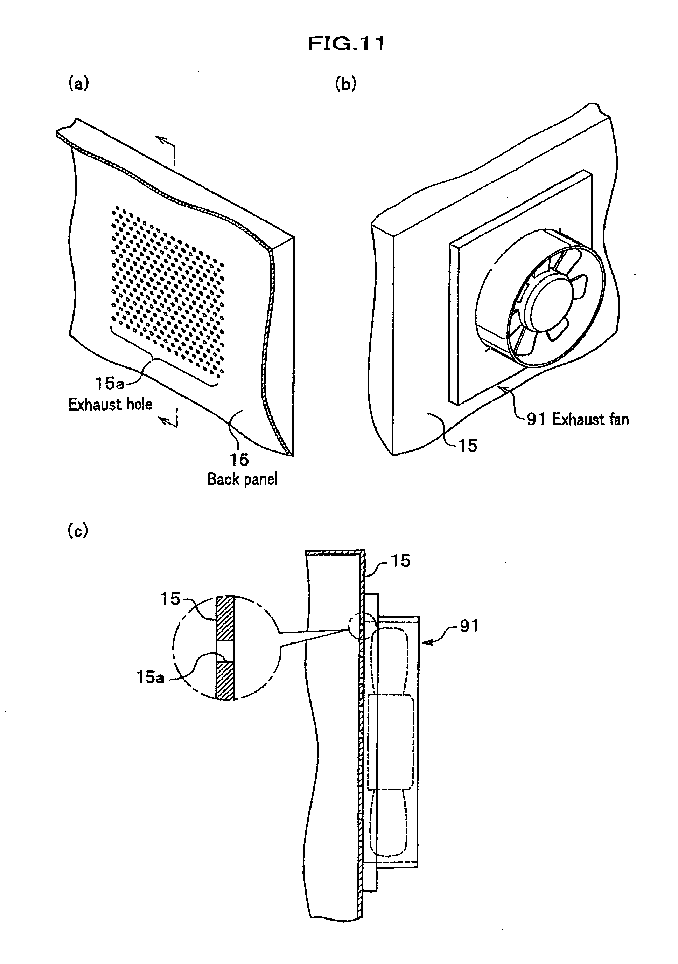

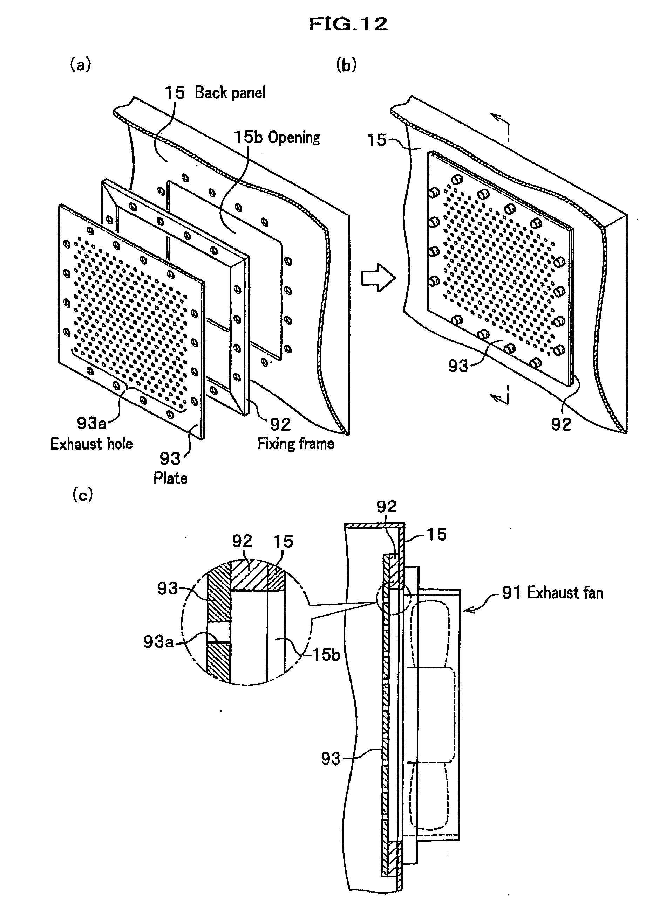

In the electronic device test box described above, a hollow of the waveguide communicates the inside and outside of the test box body. That is, the hollow of the waveguide is a communication passage for communicating between the inside and outside of the Lest box body. Further, because the waveguide does not transmit the radio wave at a wavelength longer than a predetermined wavelength, the test box body maintains its radio wave shielding capability well.
In other words, although the waveguide communicates between the inside and outside of the test box body, the waveguide also enhances the radio wave shielding capability therebetween. For example, when a radio wave necessary for performing a test propagates from the inside to the outside of the test box body, a level of the radio wave is reduced to about 30 to 40 dB.
The expression used herein "the waveguide does not transmit a radio wave at a wavelength longer than a predetermined wavelength" means that "the waveguide is designed such that a radio wave at a wavelength not longer than the predetermined wavelength can be transmitted through the waveguide well without attenuation". The waveguide according to the present invention may have a tubular outer shape, or may have a plate-like, elongate, or any other outer shape, as shown in FIG. 11 and FIG. 12 described hereinafter.

Thus, in the electronic device test box, for example, when the waveguide is a hand insertion waveguide, a tester can enter his/her hands inside the test box body via the hollow of the waveguide, and can perform a test while directly manipulating the electronic device. This case will be explained in an embodiment described hereinafter. When the waveguide is an exhaust waveguide, a heat radiated from an electronic device or the like can be discharged to the outside via the hollow of the exhaust waveguide. This case will also be explained in an embodiment described hereinafter.

The electronic device test box according to the present invention is characterized to have a plurality of the waveguides described above, and to have a plurality of the waveguides provided in a bundle.

Because the electronic device test box has a plurality of the waveguides, and a plurality of the waveguides are provided in a bundle, even when each of a plurality of the waveguides is made thinner, for example, the total cross sectional area thereof as a communication passage for communicating between the inside and outside of the test box body is sufficiently large. For example, if a cross sectional area of an opening of each waveguide is made smaller, and each waveguide is also made longer to enhance its radio wave shielding capability, the total cross sectional area is sufficiently large. More specifically, for example, if each of the waveguides is used for an exhaust operation, even when each waveguide is made smaller, an exhaust amount therefrom can be sufficiently secured, because a plurality of the waveguides are provided in a bundle.

In the electronic device test box according to the present invention, the waveguide is characterized to have a radio wave absorbing capability inside thereof.

In the electronic device test box described above, as the waveguide has the radio wave absorbing capability inside thereof, the waveguide absorbs well the radio wave at a wavelength longer than a predetermined wavelength. Otherwise, the radio wave will propagate through the hollow of the waveguide. Therefore, the radio wave shielding capability of the test box body is also maintained well.

In the electronic device test box according to the present invention, the test box body is characterized to include a metal enclosure having a radio wave shielding capability.

Because the electronic device test box described above includes the metal enclosure having the radio wave shielding capability, the electronic device test box can shield radio waves well. Further, because the enclosure is made of metal, the enclosure has an enhanced stiffness. Thus, durability of the electronic device test box is also enhanced.

In the electronic device test box according to the present invention, the metal enclosure is characterized to be constituted by assembling a plurality of metal members together, and to further have resistance loss members placed in gaps among a plurality of the metal members.

In the electronic device test box described above, the enclosure in a desired shape can be easily formed by assembling a plurality of metal members together according to the necessity. Further, because the enclosure has the resistance loss members placed in the gaps among a plurality of the metal members, the enclosure can have an excellent radio wave shielding capability.
The resistance loss members used herein mean members having a radio wave shielding capability by absorbing a radio wave.

In the electronic device test box according to the present invention, the waveguide is characterized to be made of aluminum or an aluminum alloy.
In such an electronic device test box, a weight of the waveguide can be reduced.

In the electronic device test box according to the present invention, the enclosure is characterized to be made of aluminum or an aluminum alloy.
In such an electronic device test box, a weight of the enclosure can be reduced.

In the electronic device test box according to the present invention, the test box body is characterized to have a window through which the electronic device is visible from outside.

In the electronic device test box described above, for example, how the electronic device is operating is visible from outside through the window.

In the electronic device test box according to the present invention, the window is characterized to have a radio wave shielding capability.

In the electronic device test box described above, because the window has the radio wave shielding capability, the radio wave shielding capability of the test box body can be maintained well.

In the electronic device test box according to the present invention, the window is characterized to reflect a radio wave radiated by the electronic device. The radio wave is reflected thereby in a direction in which the test box body can absorb the reflected radio wave.

in the electronic device test box described above, the radio wave reflected by the window can be absorbed within the test box body.

In the electronic device test box according to the present invention, the test box body is characterized to have a freely openable/closable door.

In the electronic device test box described above, the door can be opened and closed according to the necessity. This means that, for example, an electronic device can be freely placed in the test box body or taken out therefrom. Additionally, it is preferable to provide a frame-shaped resistance loss member on edges of the door, on which the door is in contact with the test box body. This enhances the radio wave shielding capability of the test box body, when the door is closed.

In the electronic device test box according to the present invention, the test box body is characterized to further include, inside thereof, an antenna for transmitting/receiving a radio wave to/from the electronic device.

In the electronic device test box described above, a radio wave can be transmitted/received between the antenna and the electronic device.

In the electronic device test box according to the present invention, the test box body is characterized to further include an EMI (Electro Magnetic Interference) duct which prevents electromagnetic interference and enables a cable to be wired from the outside to the inside of the test box body.

In the electronic device test box described above, the cable can be wired via the EMI duct from the outside to the inside of the test box body, while preventing electromagnetic interference.

In the electronic device test box according to the present invention, the cable is characterized to be wired via the EMI duct from the outside to the inside of the test box body, and is coated with a noise absorber for absorbing a noise.

In the electronic device test box described above, the noise absorber can absorb a noise passing through the cable. It is to be noted that the cable wired from the outside to the inside of the test box body may be, for example, a cable for connecting to the antenna, a power cable for connecting to the electronic device provided in the test box body, or the like.

As described above, the present invention can provide the electronic device test box, in which a precise test of the electronic device can be performed, while the electronic device test box maintains its radio wave shielding and absorbing capabilities, even if the electronic device test box has an opening for manipulating the electronic device, a passage for ventilation, or the like.

Various aspects and advantages described above, and other features and advantages of the present invention will become more apparent from the following exemplary and nonlimiting detailed description of the invention, when taken in conjunction with the accompanying drawings.

### BRIEF DESCRIPTION OF THE DRAWINGS

FIG. 1 is a perspective view showing an electronic device test box according to an embodiment of the present invention.
FIG. 2 is an exploded perspective view showing the electronic device test box shown in FIG. 1.
FIG. 3 is a cross sectional view showing the electronic device test box shown in FIG. 1, when cut along the line X-X.
FIG. 4(a) is an enlarged sectional side view showing a jointed part of the electronic device test box shown in FIG. 1; and FIG. 4 (b) is an enlarged view of an insulation resistance film used in the jointed part.
FIG. 5 is a side sectional view showing a hand insertion waveguide shown in FIG. 1.
FIG. 6 is a cross sectional view showing a pseudo-absorption of a radio wave by a radio wave absorbing structure of the electronic device test box according to the embodiment.
FIG. 7 is an enlarged sectional side view showing an electronic device according to a variation example.
FIG. 8 is an enlarged sectional side view showing an electronic device test box according to a variation example.
FIG. 9 is a perspective view showing an electronic device test box according to a variation example.
FIG. 10 is a perspective view showing an electronic device test box according to a variation example.
FIG. 11(a) is a view showing a back panel viewed from inside an electronic device test box according to a variation example; FIG. 11(b) is a view showing the back panel viewed from outside; and FIG. 11(c) is a cross sectional view showing the back panel.
FIG. 12(a) and FIG. 12(b) are views each showing a back panel viewed from inside an electronic device test box according to a variation example; and FIG. 12(c) is a cross sectional view showing the back panel.
FIG. 13(a) and FIG. 13(b) are views each showing a back panel viewed from inside an electronic device test box according to a variation example; and FIG. 13(c) is a cross sectional view showing the back panel.

### REFERENCE CHARACTERS

- B1, B2, B3: Electronic device test box
- 10: Test box body
- 10A: Enclosure
- 13A: Window (Door)
- 15A: FMI duct
- 20: Radio wave absorbing structure
- 23A, 24A, 25A, 26A, 27A, 28A, 29A: Spacer
- 23B, 24B, 25B, 26B, 27B, 28B, 29B: Resistant film sheet
- 31: Insulation resistant film (Resistance loss member)
- 50: Hand insertion waveguide (Radio wave shielding unit)
- 51: Hand insertion waveguide body
- 52: Radio wave absorbing sheet
- 60, 160: Exhaust waveguide (Radio wave shielding unit)
- 61: Inner exhaust waveguide
- 70: Antenna
- 73: Cable
- 75: Noise absorber
- 81: Door
- 83: Cable wiring waveguide
- 94: Aluminum fragment filter (Radio wave shielding unit)

### BEST MODES FOR CARRYING OUT THE INVENTION

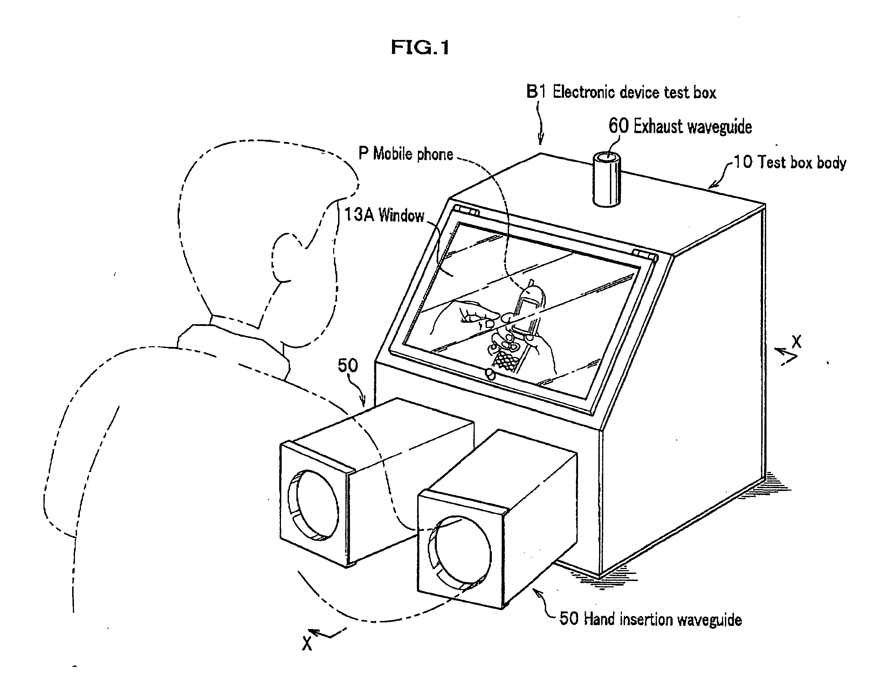

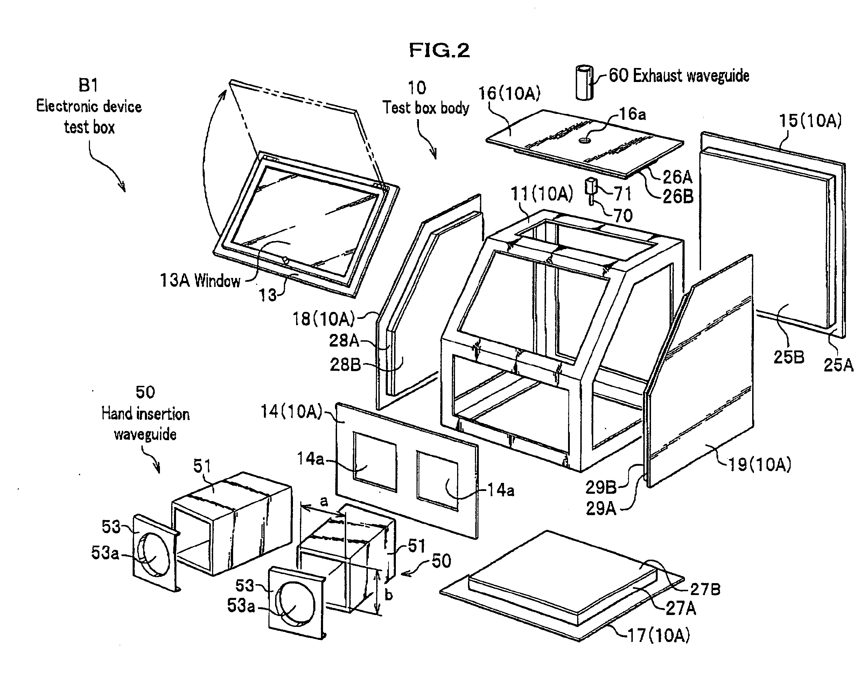

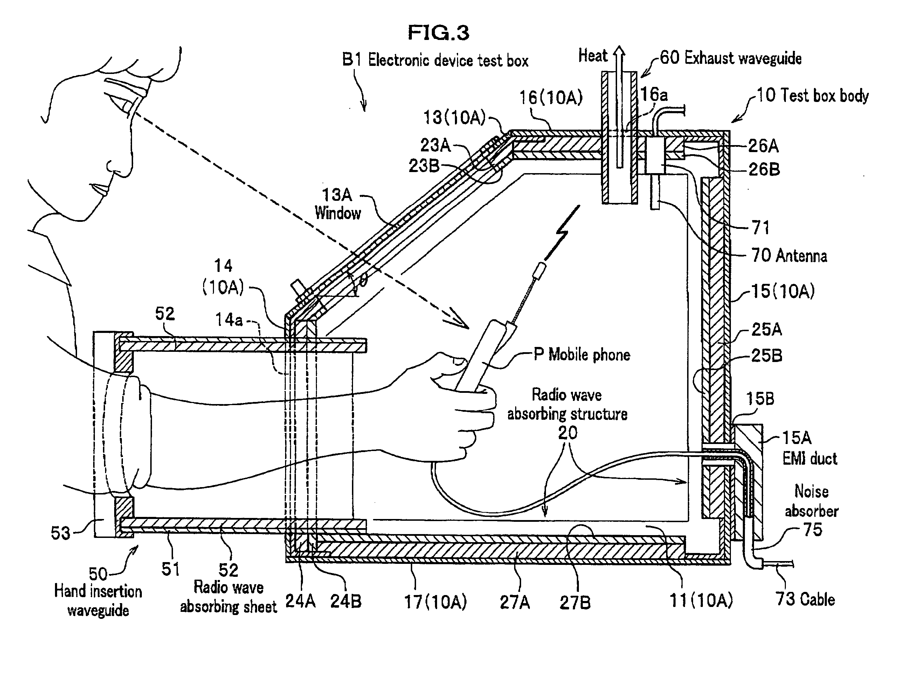

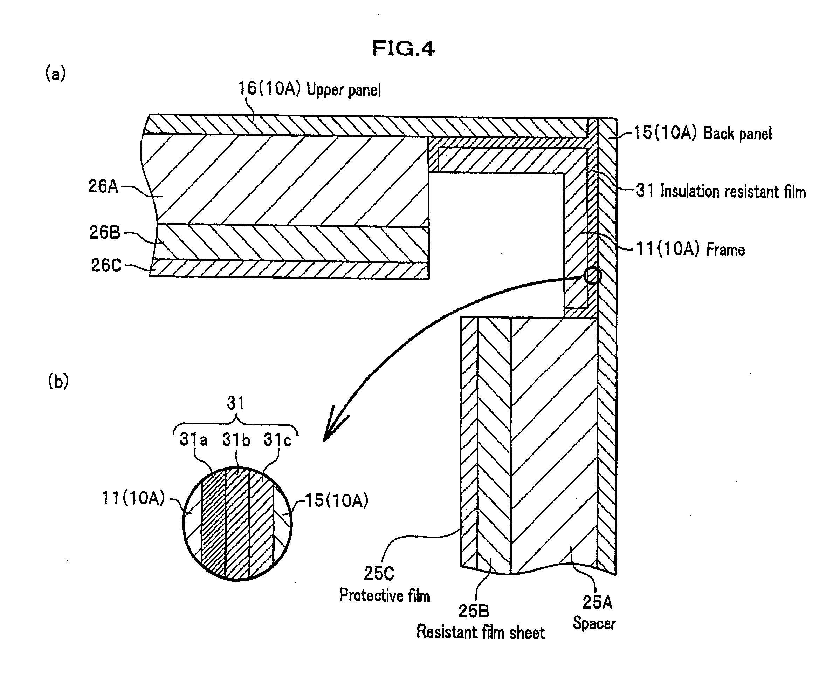

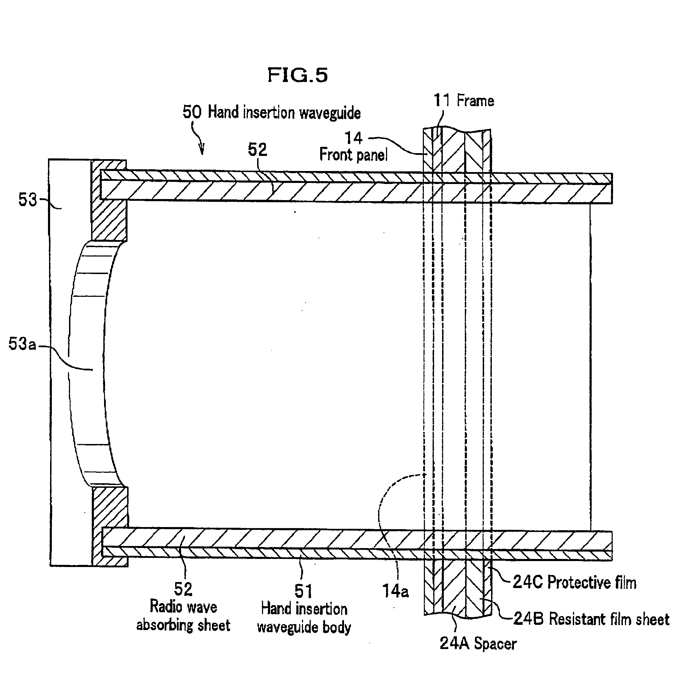

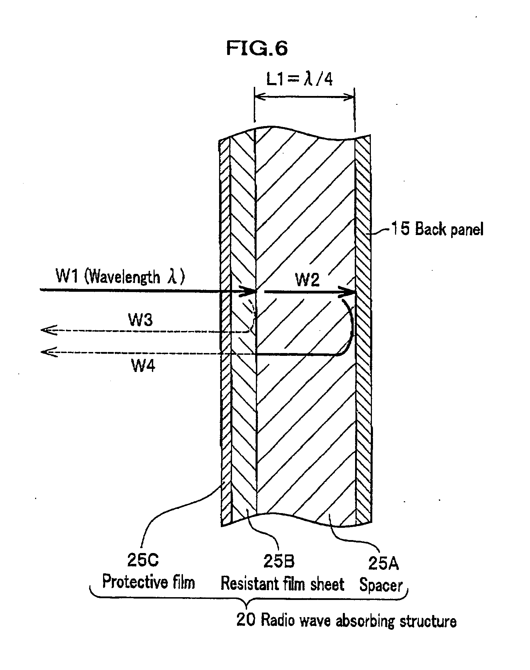

An electronic device test box according to an embodiment of the present invention is described in detail with reference to FIG. 1 to FIG. 6 according to the necessity.
In the drawings to be referred to herein, FIG. 1 is a perspective view showing an electronic device test box according to the embodiment of the present invention. FIG. 2 is an exploded perspective view showing the electronic device test box shown in FIG. 1. FIG. 3 is a cross sectional view showing the electronic device test box shown in FIG. 1, when cut along the line X-X. FIG. 4 (a) is an enlarged sectional side view showing a jointed part of the electronic device test box shown in FIG. 1; and FIG. 4(b) is an enlarged view of an insulation resistance film used in the jointed part. FIG. 5 is a side sectional view showing a hand insertion waveguide shown in FIG. 1. FIG. 6 is a cross sectional view showing a pseudo-absorption of a radio wave by a radio wave absorbing structure of the electronic device test box according to the embodiment.

As shown in FIG. 1, in an electronic device test box B1 according to the embodiment, a mobile phone P (an electronic device) is placed inside a test box body 10; a tester puts his/her hands through a pair of hand insertion waveguides 50 into the test box body 10; the tester transmits/receives a radio wave between the mobile phone P and an antenna 70 (see FIG. 3), while directly manipulating the mobile phone P with his/her hands; and the tester visually recognizes what is displayed on a liquid crystal monitor of the mobile phone P via a window 13A to perform various tests such as a radio connection test.
In the embodiment, a description is made assuming that an electronic device as is referred to in Claims is the mobile phone P. However, the electronic device is not limited to the mobile phone P, and any other electronic device is applicable in the present invention.
A configuration of the electronic device test box B1 is described below.

### <<Configuration of Electronic Device Test Box>>

As shown in FIG. 1, and also in FIG. 2 and FIG. 3 according to the necessity, the electronic device test box B1 includes, as main components, the test box body 10; a pair of the hand insertion waveguides (radio shielding units) 50,50; an exhaust waveguide (a radio shielding unit) 60; the antenna 70 provided inside the test box body 10; and a cable 73 connected to the mobile phone P provided inside the test box body 10. The waveguides that the electronic device test box B1 herein has are a pair of the hand insertion waveguides 50,50 and the exhaust waveguide 60. Each of the hand insertion waveguides 50,50 communicates the inside and outside of test box body 10 to secure circulation of air, and does not transmit a radio wave at a wavelength longer than a predetermined wavelength. The exhaust waveguide 60 secures circulation of air. Each hollow of the hand insertion waveguides 50,50 and the exhaust waveguide 60 operates as a communicating passage for communicating the inside and outside of the test box body 10.
The test box body 10, the cable 73, the antenna 70, the hand insertion waveguides 50,50 and the exhaust waveguide 60 are described below in this order for convenience of description.

### <Test box body>

The test box body 10 includes an enclosure 10A; and a λ/4 type radio wave absorbing structure 20 provided inside the enclosure 10A (see FIG. 3). The radio wave absorbing structure 20 shown in FIG. 3 has a characteristic of absorbing radio wave to be hereinafter described. This means that the test box body 10 has the radio wave absorbing capability of absorbing a radio wave radiated by the mobile phone P.
The enclosure 10A not only has the radio wave absorbing capability, but also functions as part of the radio wave absorbing structure 20 as will be hereinafter described. However, the two functions are to be described separately for convenience of explanation.

### <Enclosure>

The enclosure 10A is made of metal and is conductive. The enclosure 10A therefore has a radio wave shielding capability and a certain stiffness.
More specifically, the enclosure 10A includes, as shown in FIG. 2, a plurality of metal members assembled each in a predetermined position with bolts or the like, namely, as main components, a frame 11; a slant panel 13; a front panel 14; a back panel 15; an upper panel 16; a bottom panel 17; a left lateral panel 18; and a right lateral panel 19. The enclosure 10A further includes an insulation resistant film 31 (a resistance loss member, see FIG. 4) interposed in respective gaps between the frame 11 and each of the panels 13 to 19; and an EMI (Electro Magnetic Interference) duct 15A fixed to the back panel 15 (see FIG. 3).

### <Frame and panels>

A type of metal of which the frame 11 and the panels 13 to 19 are made is not specifically limited in the present invention, and may be a pure metal or an alloyed metal. Specific examples of the type of metal are aluminum and an aluminum alloy (hereinafter referred to as aluminum or the like). If the frame 11 and the panels 13 to 19 are made of aluminum or the like, the enclosure 10A can maintain a desired stiffness and can be made lighter in weight. It is thereby easy to handle the enclosure 10A, for example, when the enclosure 10A is moved from one place to another. Further, since aluminum or the like has its unique luster, the electronic device test box B1 can have an excellent appearance.

### <Insulation resistant film>

The insulation resistant film 31 (a resistance loss unit) has a radio wave shielding capability, and is placed in respective gaps formed between the frame 11 and each of the panels 13 to 19 (see, for example, a jointed part formed by the frame 11, the backside panel 15 and the upper panel 16 as shown in FIG. 4(a)). The insulation resistant film 31 has a three-layered structure as shown in FIG. 4(b), in which a conductive layer 31b is sandwiched between an insulating layer 31a and an insulating layer 31c.
With the configuration, the insulation resistant film 31 maintains the radio wave shielding capability of the enclosure 10A well, even though the enclosure 10A is constituted by assembling the frame 11 and the panels 13 to 19, each of which are made of metal. In other words, an interposition of the insulation resistant film 31 between such metal members makes it easy to constitute the enclosure 10A in a desired shape by assembling a plurality of metal members.
The insulation resistant film 31 may be, for example, a radio wave shielding joint sheet material having a resistance loss material, such as a carbon resistance sheet, as described in Japanese Laid-Open Patent Application, Publication No. 2000-59088. More specifically, for example, Lumidion (registered trademark) IR, manufactured by Toyo Service Inc. may be used as the insulation resistant film 31.

### <Slant panel - Window>

The slant panel 13 is provided with a window 13A, as shown in FIG. 2 and FIG. 3. The window 13A is transparent enough so that the inside of the test box body 10 is visible. The window 13A also has a radio wave shielding capability of shielding a radio wave which might penetrate through or leak from the window 13A. This can maintain the radio wave shielding capability of the enclosure 10A. The window 13A as described above can be provided by, for example, forming an ITO (Indium Tin Oxide) film on one surface of a glass plate.

The window 13A is freely openable/closable with respect to the slant panel 13, and also functions as a door as referred to in Claims. When the window 13A is opened and closed according to the necessity, the mobile phone P can be easily placed in or taken out from the enclosure 10A. Further, a frame-shaped packing (a resistance loss member) made of the same material as that of the insulation resistant film 31, or a packing having conductivity is provided on edges of the window 13A. The edges of the window 13A are in contact with the slant panel 13, when the window 13A is closed. Hence, the radio wave shield capability of the enclosure 10A is maintained well.

As shown in FIG. 3, the window 13A faces a direction, in which, when the window 13A reflects a radio wave radiated by the mobile phone P toward the radio wave absorbing structure 20, the reflected radio wave can be absorbed in the radio wave absorbing structure 20. More specifically, a slant angle θ of the window 13A with respect to the bottom panel 17, that is, the slant angle θ between the slant panel 13 and the bottom panel 17 is set at 45 degrees.

### <Bottom panel - EMI duct and cable>

The EMI duct 15A can prevent electromagnetic interference, and enables the cable 73 or the like to be inserted from the outside into the inside of the enclosure 10A. As shown in FIG. 3, the EMT duct 15A is provided on the back panel 15 via a gasket 15B. Thus the EMI duct 15A enables the cable 73 connected to the mobile phone P to be wired from the outside to the inside of the enclosure 10A, and also blocks the electromagnetic interference from an insertion part into which the cable 73 is inserted. Hence, the radio wave shielding capability of the enclosure 10A is secured.
The cable 73 is placed so that a portion of the cable 73 which passes inside the EMI duct 15A has a predetermined length (for example, 100 mm or longer), as shown in FIG. 3. This enables the electromagnetic interference to be blocked suitably.

Outer circumferential surfaces of the above-mentioned portion of the cable 73 which passes inside the EMI duct 15A, and outer circumferential surfaces of portions which are adjacent to the above-mentioned portion are coated with a noise absorbing material 75. The noise absorbing material 75 absorbs a noise which passes through the cable 73. Therefore, a radio wave transmitted or received by the mobile phone P can be controlled/measured with a high precision using a transmitting and receiving unit (not shown) or the like. The noise absorbing material 75 is obtained by, for example, winding the cable 73 with the EMI tape Lumidion (registered trademark) ET, manufactured by Toyo Service Inc., with a predetermined length (for example, 300 mm or longer).

As shown in FIG. 2, two hand insertion openings 14a, 14a are provided on the front panel 14, and an exhaust hole 16a is provided on the upper panel 16.

### <Antenna>

The antenna 70 transmits/receives a radio wave to/From the mobile phone P, and is hung down from the upper panel 16 via an antenna holder 71. A cable connected to the antenna 70 is pulled out from a through hole formed on the upper panel 16 to the outside of Lhe test box body 10, and is then connected to a transmitting and receiving unit (not shown). The transmitting and receiving unit can control/measure a radio wave transmitted or received between the antenna 70 and the mobile phone P.

### <λ/4 type radio wave absorbing structure>

The λ/4 type radio wave absorbing structure 20 is described with reference to FIG. 2, FIG. 3 and FIG. 6 according to the necessity. The radio wave absorbing structure 20 has a structure based on a known method for absorbing a radio wave. The radiowave absorbing structure 20 is provided so as to cover an inner circumferential surface of the enclosure 10A, and pseudoly absorbs a radio wave radiated by the mobile phone P. In other words, the radio wave absorbing structure 20 prevents the radio wave radiated by the mobile phone P from resonating, even if the radio wave is reflected by an inner surface of the enclosure 10A. The radio wave absorbing structure 20 also prevents a precision of a test of the mobile phone P from deteriorating.

The radio wave absorbing structure 20 includes, as main components, the enclosure 10A; the spacers 23A, 24A, 25A, 26A, 27A, 28A, 29A, provided on the inner surface of the enclosure 10A each in a position corresponding to respective panels 13 to 19; the resistant film sheets 23B, 24B, 25B, 26B, 27B, 28B, 29B each provided on an inner surface of respective spacers 23A to 29A, and each having a capability of allowing a 1/2 of an incident radio wave energy to pass therethrough; and a plurality of protective films provided on an inner surface of the respective resistant film sheets 23B to 29B.
It is to be noted that the protective films are not shown in FIG. 3. However, a protective film 24C inside the front panel 14 is shown in FIG. 5; a protective film 25C inside the back panel 15, in FIG. 4 and FIG. 6; and a protective film 26C inside the upper panel 16, in FIG. 4.

With reference to FIG. 3, for example, how the spacer 23A, a resistant film sheet 23B and a protective film not shown are arranged on the slant panel 13 is described. The spacer 23A is attached on an inner surface of the slant panel 13. On the inner surface of the spacer 23A is attached the resistant film sheet 23B. And, on an inner surface of the resistant film sheet 23B, the protective film. The expression "on an inner surface" used herein means "on an inner surface of the enclosure 10A". Each arrangement of the other spacers 24A to 29A, the other resistant film sheets 24B to 29B, and the other protective films is the same as above.

### <Spacer>

The spacers 23A to 29A allow a radio wave to transmit therethrough. The spacers 23A to 29A are also used for setting respective distances between the resistant film sheets 23B to 29B and the panels 13 to 19 (the enclosure 10A) at λ/4. That is, each of the spacers 23A to 29A has a thickness L1 of λ/4 (see FIG. 6). It is assumed herein that a wavelength of a radio wave W1 radiated by the mobile phone P or the like is λ.
The spacers 23A to 29A may be made of any material, as long as a radio wave can transmit therethrough. For example, The spacers 23A to 29A may be made of styrofoam. If the spacers 23A to 29A are made of styrofoam, each thickness L1 of the spacers 23A to 29A can be easily adjusted.

### <Resistant film sheet and protective film>

Each of the resistant film sheets 23B to 29B is a thin sheet having a certain surface resistance value which is adjusted so as to be substantially equal to a free-space impedance (376.7Ω). Such a resistant film sheet can be obtained by applying carbon conductive coating to a sheet, or by adjusting a resistance value of an ITO film to form a sheet.
The protective films (see FIG. 4 to FIG. 6) are layered on respective inner surfaces of the resistant film sheets 23B to 29B, and can protect the surfaces of the resistant film sheets 23B to 29B.

With reference to FIG. 6, the radio wave absorbing structure 20 on the back panel 15 (a portion of the enclosure 10A) is further described. The radio wave absorbing structure 20 on the back panel 15 includes the spacer 25A, the resistant film sheet 25B, and the protective film 25C, which are layered up in this order on the inner surface of the back panel 15. For simplification, a description herein is made assuming that a radio wave enters the protective film 25C at right angles.

After the radio wave W1 radiated by the mobile phone P or the antenna 70 passes through the protective film 25C, a 1/2 of the radio wave W1 further passes through the resistant film sheet 25B, and the other 1/2 is reflected by the same. Herein the passed-through radio wave is referred to as a radio wave W2, and the reflected radio wave, a radio wave W3. The radio wave W2 then passes through the spacer 25A, and is reflected by the back panel 15, which has the radio wave shielding capability. The reflected radio wave is referred to as a radio wave W4. It is to be noted that each of the reflected radio waves is reversed in phase.
When the radio wave W4 reaches the resistant film sheet 25B, the radio wave W4 plus the radio wave W2 travel longer than the radio wave W3, which has been reflected by the resistant film sheet 25B, by twice the thickness L1 of the spacer 25A, that is, "λ/4×2=λ/2". And further, the radio wave W3 and the radio wave W4 are opposite each other in phase. The radio wave W3 and the radio wave W4 are therefore cancelled each other. This results in a pseudo-absorption of the radio wave W1 incident to the resistant film sheet 25B.

### <Hand insertion waveguide>

Returning to FIG. 1 and FIG. 2, the hand insertion waveguides 50,50 are described.
Each of the two hand insertion waveguides 50,50 communicates between the inside and outside of the test box body 10, so that the tester can enter his/her hands in the test box body 10. Each of the hand insertion waveguides 50,50 does not transmit a radio wave at a wavelength longer than a predetermined wavelength. Each of the hand insertion waveguides 50,50 is fixed to the front panel 14, so as to be slightly outward-angled on a hand insertion side thereof, when viewed from above. The other end of the hand insertion side of each hand insertion waveguide 50 protrudes inside the test box body 10 (see FIG. 3 and FIG. 5).
As shown in FTG. 1, FIG. 2, FIG. 3 or FIG. 5 according to the necessity, each hand insertion waveguide 50 includes a hand insertion waveguide body 51; a radio wave absorbing sheet 52; and a cover 53. The radio wave absorbing sheet 52 may also be referred to as a broadband absorbing material, because of its radio wave absorbing capability in a broad bandwidth.

### <Hand insertion waveguide body>

The hand insertion waveguide body 51 is a metal tube having a rectangle-shaped cross section and made of aluminum or the like. The hand insertion waveguide body 51 also has the radio wave shielding capability. A hollow of each hand insertion waveguide body 51 communicates with the inside of the test box body 10 via each hand insertion opening 14a on the front panel 14. The tester can insert his/her hand into the test box body 10 via the hollow.

The rectangle which constitutes the cross section of each hand insertion waveguide body 51 has a long side, "a", and a short side, "b" (see FIG. 2). Each length of the long side "a" and the short side "b" is set based on a wavelength of the radio wave, which the hand insertion waveguide body 51 does not allow to transmit therethrough. In this embodiment, the each length of the long side "a" and the short side "b" is set such that a radio wave at a wavelength longer than a predetermined wavelength does not transmit through the hand insertion waveguide 61.
It is thus prevented that the radio wave at a wavelength longer than the set wavelength transmits through the hollow of the hand insertion waveguide body 51. Hence the radio wave shielding capability of the test box body 10 is suitably maintained. A precision in operation tests of the mobile phone P can also be ensured.
It is to be noted that a shape of the cross section of each hand insertion waveguide body 51 is not limited to the rectangle described above, and may be any other shape, for example, a circle.
Generally, if there are a plurality of waveguides having the same shape and size (length) of its openings, the longer the waveguide is, the higher its radio wave shielding capability becomes. Though depending on the shape of the opening of the waveguides, the smaller an area of the opening is, the higher a limit frequency (a predetermined frequency) of a radio wave which the waveguide can block becomes.

### <Radio wave absorbing sheet>

The radio wave absorbing sheet, 52 covers an inner circumferential surface of the hand insertion waveguide body 51. The hand insertion waveguide body 51 absorbs even a very weak radio wave at a wavelength longer than the set predetermined wavelength. Otherwise, such radio wave will propagate in the hand insertion waveguide body 51. The radio wave absorbing sheet 52 enhances the capability of the hand insertion waveguide body 51 of not allowing the set radio wave to transmit therethrough. As a result, each hand insertion waveguide 50 has a radio wave absorbing capability inside thereof.

The radio wave absorbing sheet 52 used herein may be, for example, a dipole type radio wave absorbing sheet. The dipole type radio wave absorbing sheet includes: (1) a sheet prepared with a compound of carbon powder, a titanium oxide and the like, and capable of absorbing a radio wave by making use of an electric field generated by the compound (for example, changes of an electronic configuration in the compound); (2) a sheet prepared with a compound of a ferrite, a carbonyl iron and the like, and capable of absorbing a radio wave by making use of a magnetic field generated by the compound (for example, changes of the magnetic field); and (3) a sheet prepared with a composite of a resin (for example, a polyurethane) and a magnetic substance. More specifically, the radio wave absorbing sheet 52 may be, for example, the Lumidion (registered trademark) IR, manufactured by Toyo Service Inc., HTD-101 manufactured by Hitachi Metals, Ltd., or the like.

### <Cover>

As shown in FIG. 2 and FIG. 3, each cover 53 is fixed on the hand insertion side of the hand insertion waveguide body 51 in such a way that each cover 53 covers up the hand insertion side. Each cover 53 has thereon a circular hand insertion hole 53a, into which a hand of the tester can be inserted. Each hand insertion hole 53a has a diameter smaller than that of the opening of each hand insertion waveguide body 51 which is covered with the radio wave absorbing sheet 52. This prevents a hand, an arm, clothes or the like inserted into the hand insertion hole 53a from directly contacting the radio wave absorbing sheet 52, which is generally highly-priced, and from damaging the radio wave absorbing sheet 52 owing to friction. Additionally, because the radio wave absorbing sheet 52 is not easily seen from the hand insertion side, the hand insertion waveguide 50 can have a good appearance.

### <Exhaust waveguide>

With reference to FIG. 2 and FIG. 3, the exhaust waveguide 60 is described next.
The exhaust waveguide 60 is a tube provided on the test box body 10. The exhaust waveguide 60 communicates between the inside and outside of the test box body 10 so as to exhaust heat radiated from Lhe mobile phone P or the like. The exhaust waveguide 60 does not transmit a radio wave at a wavelength longer than a predetermined, wavelength. The exhaust waveguide 60 is fixed on the upper panel 16 of the test box body 10. A hollow of the exhaust waveguide 60 communicates with the inside of the test box body 10 via an exhaust hole 16a formed on the upper panel 16. One end of the exhaust waveguide 60 protrudes inside the test box body 10 (see FIG. 3).
With this configuration, the radiated heat can be exhausted to the outside vi a the exhaust hole 16a and the hollow of the exhaust waveguide 60. This prevents the inside of the test box body 10 from reaching a high temperature.

A configuration of the exhaust waveguide 60 is the same as that of the hand insertion waveguide 50. The exhaust waveguide 60 also has the capability of not allowing a radio wave at a wavelength longer than a predetermined wavelength to transmit therethrough. Thus the description is omitted herefrom. Though not shown, it is needless to say that the radio wave absorbing sheet 52 can be provided inside the exhaust waveguide 60.

With the electronic device test box B1 described above, a tester opens Lhe window 13A to place the mobile phone P into the test box body 10; inserts his/her hands from a pair of the hand insertion waveguides 50; transmits/receives a radio wave between the mobile phone P and the antenna 70, while directly manipulating the mobile phone P, and while visually recognizing what is displayed on a liquid crystal monitor of the mobile phone P via the window 13A; and can precisely perform a test of the mobile phone P, such as a radio wave connection test. Additionally, because the heat radiated from the mobile phone P or the like is exhausted to the outside of the test box body 10 via the exhaust waveguide 60, the inside of the test box body 10 is prevented from reaching a high temperature.
Further, the radio wave absorbing structure 20 can pseudoly absorb a radio wave radiated toward the mobile phone P, the antenna 70, and the inner circumferential surface of the Lest box body 10, without resonance due to a reflected radio wave. This maintains a good condition for performing a test. Moreover, each hand insertion waveguide 50 and the exhaust waveguide 60 do not transmit a radio wave at a wavelength longer than a predetermined waveguide. This prevents the radio wave shielding capability of the test box body 10 from deteriorating, and ensures a good condition for performing the test.

The present invention has been described above with reference to the preferred embodiment. However, the present invention is not limited to the embodiment, and various changes, for example, those as shown below are possible without departing from the spirit and scope of the present invention.

In the above-described embodiment, the electronic device test box B1 includes two hand insertion waveguides 50,50 and one exhaust waveguide 60. However, the number of the waveguides is not limited to this, and can be changed according to the necessity. For example, additional hand insertion waveguides 50 may be provided, so that a plurality of testers can operate a plurality of the mobile phones P.
The waveguides for communicating between the inside and outside of the test box body 10 are not limited to be used for a hand insertion and an exhaust, but may be used for an air intake, a wiring, or other purposes. That is, the electronic device test box B1 may have, for example, both the exhaust waveguide 60 and a waveguide for the air intake.

The electronic device test box B1 according to the above-described embodiment includes the tubular exhaust waveguide 60, which is provided on the upper surface of the test box body 10. However, a shape or a position of the exhaust waveguide 60 is not limited to this, and can be changed according to the necessity.

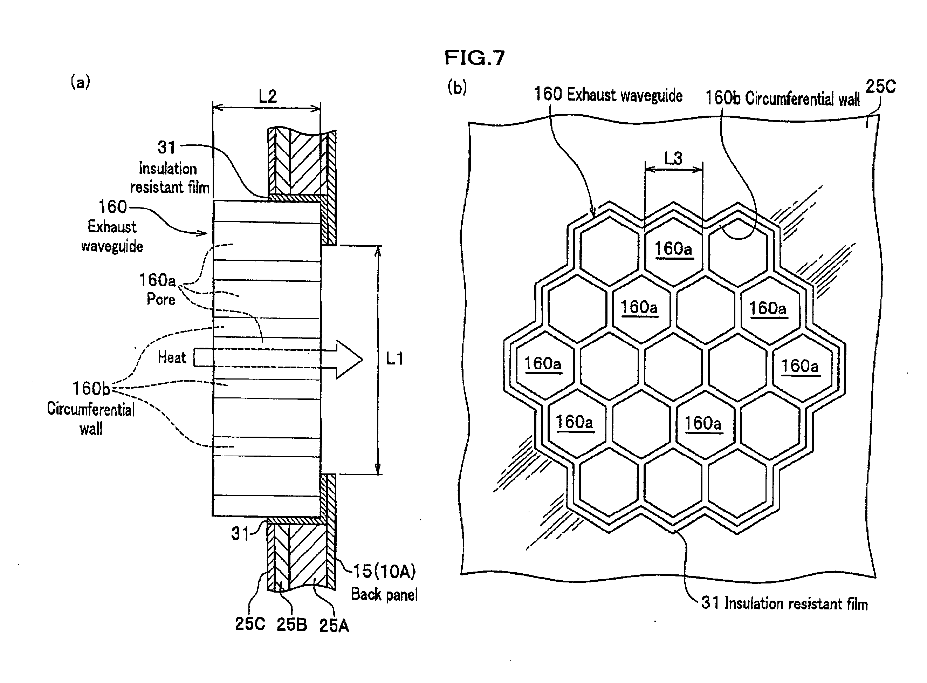

For example, in place of the exhaust waveguide 60, an exhaust waveguide 160 may be provided on the back panel 15 of the test box body 10, as shown in FIG. 7(a). The exhaust waveguide 160 is a honeycomb member made of metal (for example, an aluminum alloy) and having a plurality of small pores 160a as shown in FIG. 7(b). The honeycomb member made of metal is also called a metal honeycomb. The exhaust waveguide 160 communicates between the inside and outside of the Lest box body 10 via a plurality of the small pores 160a, through which heat can be exhausted.

For a further description of the exhaust waveguide 160, each of the small pores 160a is surrounded by a circumferential wall 160b, and has a cross section in a regular hexagonal shape. It is to be noted that the cross section of each small pore 160a is not limited to be the regular hexagonal, and may be a square or any other shape.
Each tubular circumferential wall 160b surrounding each small pore 160a operates as a waveguide. That is, the exhaust waveguide 160 is constituted by a plurality of the circumferential walls 160b bundled together.
To attach the exhaust waveguide 160 onto the test box body 10, an opening having a diameter L1 is created on the test box body 10 as shown in FIG. 7 (a). The opening diameter L1, a length L2 of the exhaust waveguide 160 (namely, a length of each tubular waveguide constituting the exhaust waveguide 160), and an opening diameter L3 of each hexagonal small pore 160a are determined, as in the case of the hand insertion waveguide 51, based on the wavelength of a radio wave not allowed to transmit through the exhaust waveguide 160 (for example, L1=79. mm, L2=12.-/ 7 mm, and L3=3. 18 mm).
Further, the three-layered insulation resistant film 31 is arranged in a gap formed by the exhaust waveguide 160, the back panel 15, the spacer 25A, the resistant film sheet 25B, and the protective film 25C. This suitably maintains the radio wave shielding capability of the test box body 10. However, the radio wave shielding capability may be maintained not only by the insulation resistant film 31 but also by filling the gap with a spongy foam having electrical conductivity.

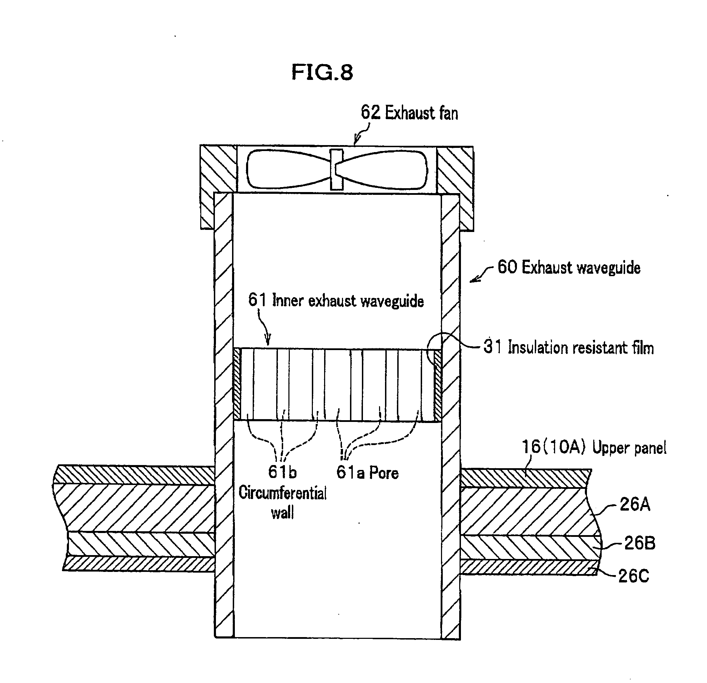

As shown in FIG. 8, an inner exhaust waveguide 61 may be additionally provided inside the exhaust waveguide 60 according to the above-described embodiment, in a suitable position in a longitudinal direction of the exhaust waveguide 60. The inner exhaust waveguide 61. is also a metal honeycomb member, as in the case of the exhaust waveguide 160 described above (see FIG. 7(a) and FIG. 7(b)). The inner exhaust waveguide 61 has a plurality of small pores 61a. Each circumferential wall 61b surrounding each small porc 61a operates as a waveguide. Namely, in FIG. 8, the exhaust waveguide 60 having inside thereof the inner exhaust waveguide 61, that is, a double-structured waveguide (a multiple waveguide) is provided on the upper panel 16 of the test box body 10.

Hence, a configuration (an opening diameter, a length, or the like) of the outer-positioned exhaust waveguide 60 can be set separately from that of the inner exhaust waveguide 61 (in further detail, an opening diameter of each small pore 61a of the inner exhaust waveguide 61, a length of each small pore 61a, or the like). This means that a wavelength of a radio wave which is not allowed to transmit through the exhaust waveguide 60 can be set differently from that of a radio wave which is not allowed to transmit through each small pore 61a of the inner exhaust waveguide 61. As a result, the radio wave shielding capability of the entire exhaust waveguide 60 can be enhanced.

Further, a plurality of inner exhaust waveguides 61 having the small pores 61a with different opening diameters and/or different lengths may be provided in the exhaust waveguide 60 in its longitudinal direction in a plurality of stages (a multistage waveguide), to thereby enhance the radio wave shielding capability of the exhaust waveguide 60. Or, an inner exhaust waveguide 61 may be provided which has small pores 61a whose opening diameters and lengths are varied according to the necessity. Or, a further smaller exhaust waveguide can be provided in each small pore 61a (a triple structure waveguide).
It is to be noted that not only the exhaust waveguide 60, but also the hand insertion waveguide 50 (see FIG. 3), an air intake waveguide, a wiring waveguide, or the like may have a configuration in which inner waveguides are arranged in multiple structures and/or in multiple stages.

As shown in FIG. 8, the insulation resistant film 31 is preferably provided in a gap between the exhaust waveguide 60 and the inner exhaust waveguide 61 to enhance the radio wave shielding capability. It is also preferable to provide an exhaust fan on an upper end of the exhaust waveguide 60, which is a downstream side of the exhaust waveguide 60, to thereby enhance an exhausting capability of the exhaust waveguide 60.

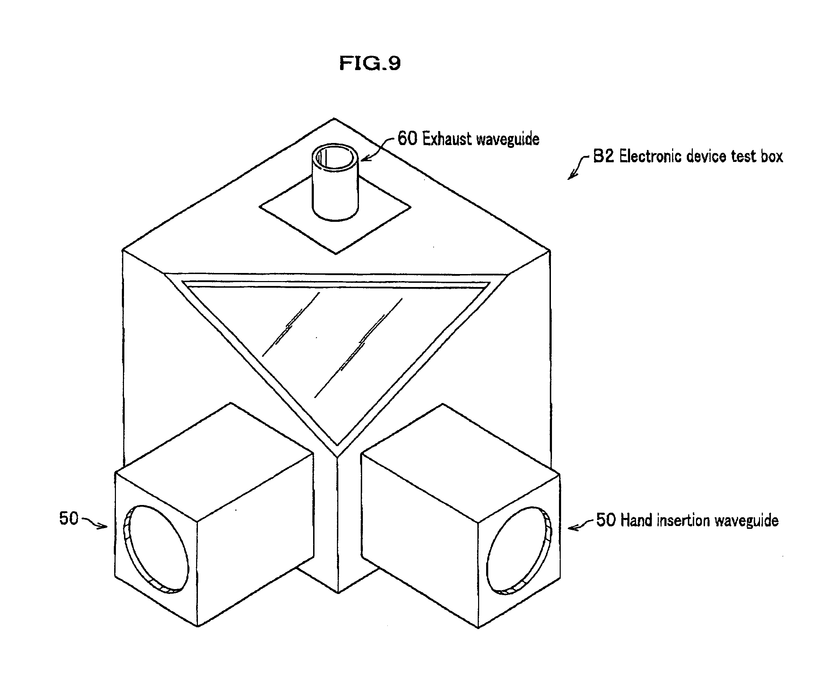

In the electronic device test box B1 according to the above-described embodiment, the hand insertion waveguides 50,50 are provided on a front side of the test box body 10. However, a position of the hand insertion waveguides 50,50 is not limited to this. For example, as shown in FIG. 9, an electronic device test box B2 may be used in which the hand insertion waveguides 50,50 are provided on adjacent surfaces.

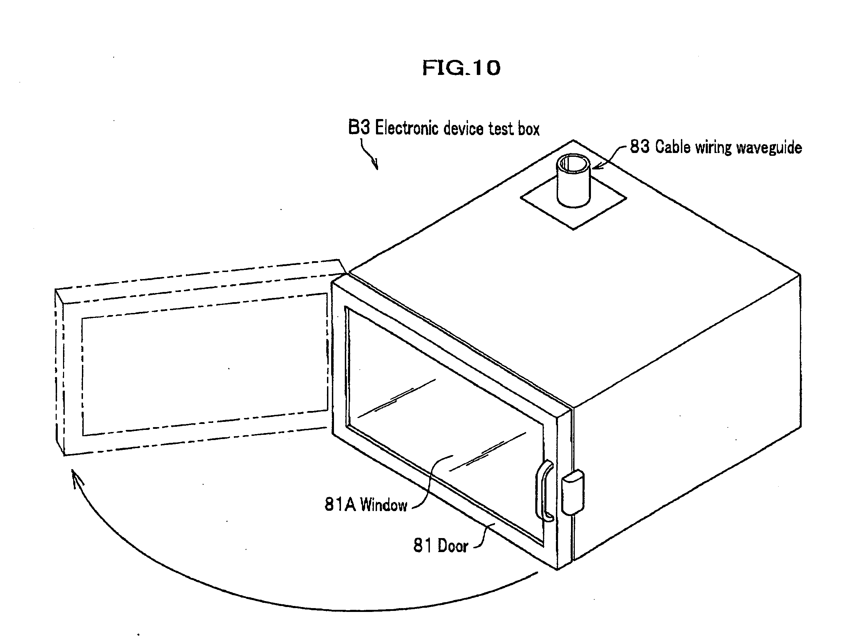

The electronic device Lest box B1 according to the above-described embodiment has the hand insertion waveguides 50, 50 and the exhaust waveguide 60. However, as shown in FIG. 10, an electronic device test box B3 may be used which does not have those waveguides.
For further description with reference to FIG. 10, the electronic device test box B3 includes a freely openable/closable door 81 having a window 81A on a front side thereof. The window 81A has the same configuration as that of the window 13A according to the above-described embodiment. When the door 81 is closed, the electronic device test box 83 has a substantially rectangular solid shape. A cable wiring waveguide 83 is provided on an upper surface of the Electronic device test box B3. A hollow of the cable wiring waveguide 83 communicates between the inside and outside of the electronic device test box B3. Cables can be suitably wired to an antenna (not shown), an electronic device (not shown), and the like provided inside the electronic device test box B3, via the hollow of the cable wiring waveguide 83.

In the above-described embodiment, the test box body 10 includes the metal enclosure 10A to enhance the stiffness and the radio wave shielding capability of the test box body 10. However, the test box body 10 may be a box made of plate materials having a radio wave absorbing capability. The same configuration can be applied to the hand insertion waveguide 50. The hand insertion waveguide 50 may be a tube made of the plate materials.

In the above-described embodiment, the spacers 23A to 29A each having the thickness L1 of λ/4 are provided. However, if it is possible to set each distance between the panels 13 to 29 and respective resistant film sheets 233 to 29B at λ/4, the spacers 23A to 29A are not necessary. In this case, however, it is required for respective spaces between the panels 13 to 29 and the resistant film sheets 23B to 29B to allow a radio wave to transmit therethrough.

In the above-described embodiment, the test box body 10 has the radio wave absorbing capability, because the radio wave absorbing structure 20 is provided inside the enclosure 10A; and the hand insertion waveguide 50 has the radio wave absorbing capability, because the radio wave absorbing sheet 52 is provided inside Lhe hand insertion waveguide body 51. However, for example, the test box body 10 may have the radio wave absorbing capability by providing the radio wave absorbing sheet 52 inside the enclosure 10A.

In the above-described embodiment, the enclosure 10A has a structure assembled with the frame 11 and each of the panels 13 to 19; and the insulation resistant film 31 is placed in a gap each formed by the frame 11 and each of the panels 13 to 19, to thereby enhance the radio wave shielding capability of the enclosure 10A. However, for example, if the frame 11 and each of the panels 13 to 19 are firmly joined together by means of welding or the like, the insulation resistant film 31 may not be necessary.

In the above-described embodiment, the window 13A is freely openable/closable with respect to the slant panel 13, and the window 13A thereby operates also as a door, as referred to in Claims. However, an additional door may be provided other than the window 13A.

In the above-described embodiment, the hand insertion waveguide 50 is fixed to the front panel 14, such that one end of the hand insertion waveguide 50 protrudes inside the test box body 10. However, for example, one end of the hand insertion waveguide 50 may be fixed just onto the front panel 14 without protruding. The same configuration can be applied to the exhaust waveguide 60.

In the above-described embodiment, it is the exhaust waveguide 60 that performs an exhaust operation. However, a plurality of exhaust holes (which may also be referred to as vent holes) 15a may perform the exhaust operation. A plurality of the exhaust holes 15a are formed on the back panel 15 (see FIG. 11(a)), and an exhaust fan 91 is attached to the outer surface of the back panel 15 (see FIG. 11(b)). In this case, an inner diameter and a length of each exhaust hole 15a are determined such that each exhaust hole 15a operates as a waveguide which does not transmit a radio wave at a wavelength longer than a predetermined wavelength (see FIG. 11(c)). Namely, each of a plurality of the exhaust holes 15a formed on the back panel 15 corresponds to a hollow of a waveguide. The back panel 15 may be called a waveguide aggregate plate, in which the waveguides are aggregated in a bundle. More specifically, for example, about 100 exhaust holes 15a each having a diameter of 3.0 mm are formed on the back panel 15 having a thickness of 10 mm. It is obvious, however, that such a plurality of the vent holes can be used not only for the exhaust operation but also for an air intake.

A plurality of the exhaust holes 15a formed on the back panel 15 is described above (see FIG. 11 (a) to FIG. 11 (c)). Instead, as shown in FIG. 12(a) to FIG. 12(c), a relatively large opening 15b may be formed on the back panel 15. A plate 93 having a plurality of exhaust holes 93a thereon (see FIG. 12(a)) is fixed onto the back panel 15 via a fixing frame 92, such that the opening 15b is covered from the inside of the electronic device test box B1 (see FIG. 12 (b)). In this case, an inner diameter and a length of each exhaust hole 93a are determined, as in the case of the exhaust hole 15a, so that each exhaust hole 93a operates as a waveguide which does not transmit a radio wave at a wavelength longer than a predetermined wavelength (see FIG. 12 (c)). Because the exhaust holes 93a are formed on the plate 93, not on the back panel 15, the plate 93 can be easily replaced according to a given radio wave which is not allowed to be transmitted between the inside and outside of the electronic device test box B1.

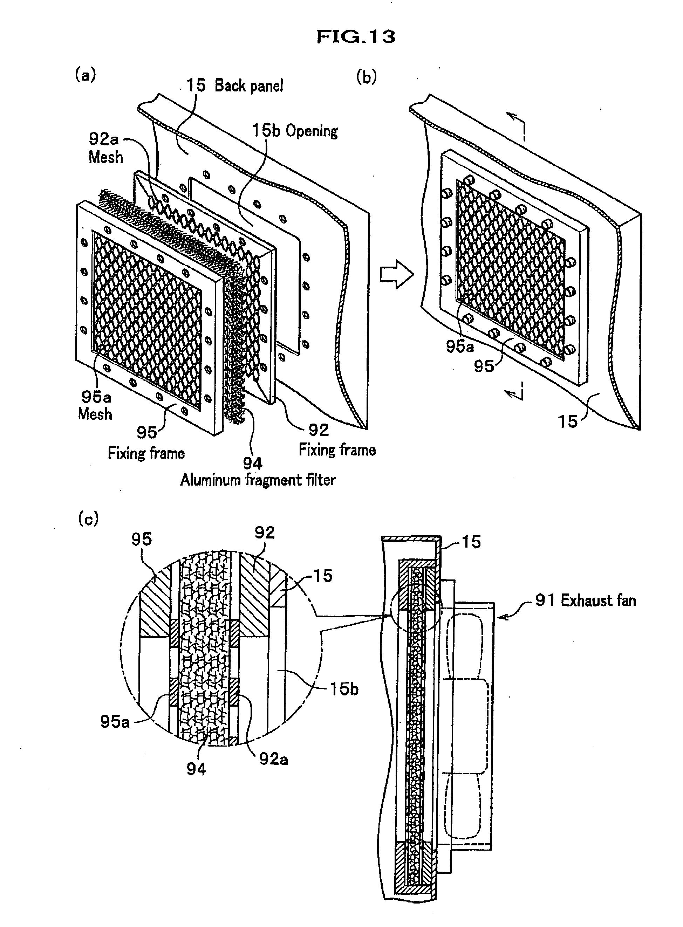

Instead of the plate 93 with the exhaust holes 93a formed thereon, an aluminum fragment filter 94 (a radio wave shielding unit) may be used (see FIG. 13(a)). The aluminum fragment filter 94 is also called an expanded aluminum filter. The aluminum fragment filter 94 is fixed onto the back panel 15 via a mesh 92a, which is attached on the fixing frame 92. Further, a mesh 95a, which is attached on a fixing frame 95, is provided on the aluminum fragment filter 94 on an opposite side of the back panel 15 (see FIG. 13(b) and FIG. 13(c)). The aluminum fragment filter 94 (or a metal filter) is constituted by assembling aluminum or aluminum alloy fragments (or metal fragments) together, and has gaps for circulating air inside thereof. The exhaust fan 91 exhausts air in the electronic device test box B1 through the gaps of the aluminum fragment filter 94 to the outside.
Meanwhile, a radio wave may reach a gap of the aluminum fragment filter 94 to travel further into the gap. However, the radio wave is subjected to a diffraction loss in the gap by the aluminum fragments or the like constituting the aluminum fragment filter 94. This maintains the radio wave shielding capability of the test box body 10. It is to be noted that "a radio wave is subjected to a diffraction loss" means that "a radio wave is reflected by a plurality of aluminum fragments or the like, and hardly propagates on a back side of the aluminum fragments (that is, in a traveling direction of the radio wave).
In place of the aluminum fragment filter 94, a steel wool, or a mesh layered material, which is made of a plurality of meshes stacked in layers, can be used as the radio wave shielding unit.

## Claims

1. An electronic device test box capable of accommodating an electronic device inside thereof for testing operations of the electronic device, comprising:
a test box body having a radio wave shielding capability, and a radio wave absorbing capability of absorbing a radio wave radiated by the electronic device; and
a radio wave shielding unit for shielding a radio wave, while securing circulation of air between an inside and outside of the test box body.

2. The electronic device test box according to Claim 1, wherein the radio wave shielding unit has a metal filter for shielding a radio wave by diffraction loss.

3. The electronic device test box according to Claim 1, wherein Lhe radio wave shielding unit has a waveguide, which is provided on the test box body for communicating between the inside and outside of the test box body, and which does not transmit a radio wave at a wavelength longer than a predetermined wavelength.

4. The electronic device test box according to Claim 3, wherein the electronic device test box has a plurality of the waveguides, and a plurality of the waveguides are provided in a bundle.

5. The electronic device test box according to Claim 3 or 4, wherein each of the waveguides has a radio wave absorbing capability inside thereof.

6. The electronic device test box according to Claim 1, wherein the test box body has a metal enclosure having a radio wave shielding capability.

7. The electronic device test box according to Claim 6, wherein the metal enclosure is constituted by assembling a plurality of metal members together, and further has resistance loss members placed in gaps among a plurality of the metal members.

8. The electronic device test box according to Claim 3 or 4, wherein each waveguide is made of aluminum or an aluminum alloy.

9. The electronic device test box according to Claim 6 or 7, wherein the enclosure is made of aluminum or an aluminum alloy.

10. The electronic device test box according to Claim 1, wherein the test box body has a window through which the electronic device is visible.

11. The electronic device test box according to Claim 10, wherein the window has a radio wave shielding capability.

12. The electronic device test box according to Claim 10 or 11, wherein the window reflects a radio wave radiated by the electronic device, and the radio wave is reflected in a direction in which the test box body absorbs the reflected radio wave.

13. The electronic device Lest box according to Claim 1, wherein the test box body has a freely openable and closable door.

14. The electronic device test box according to Claim 1, wherein the test box body further has, inside thereof, an antenna for transmitting a radio wave to and receiving a radio wave from the electronic device.

15. The electronic device test box according to Claim 1, wherein the test box body further has an Electro Magnetic Interference (EMI) duct for wiring a cable from the outside to the inside of the test box body, while preventing electromagnetic interference.

16. The electronic device test box according to Claim 15, wherein the cable is wired via the EMI duct from the outside to the inside of the test box body, and is coated with a noise absorber for absorbing a noise.
